(19) Europäisches Patentamt
European Patent Office
Office européen des brevets

(11) EP 1 655 359 A1

(12) # EUROPÄISCHE PATENTANMELDUNG

(43) Veröffentlichungstag:
**10.05.2006 Patentblatt 2006/19**

(51) Int Cl.:
***C09K 11/06*** *(2006.01)* ***H01L 51/30*** *(2006.01)*

(21) Anmeldenummer: **04026402.0**

(22) Anmeldetag: **06.11.2004**

(84) Benannte Vertragsstaaten:
**AT BE BG CH CY CZ DE DK EE ES FI FR GB GR HU IE IS IT LI LU MC NL PL PT RO SE SI SK TR**
Benannte Erstreckungsstaaten:
**AL HR LT LV MK YU**

(71) Anmelder: **Covion Organic Semiconductors GmbH**
**65926 Frankfurt am Main (DE)**

(72) Erfinder:
- **Philip Stössel**
  **65929 Frankfurt (DE)**
- **Esther Breuning**
  **65527 Niedernhausen (DE)**
- **Horst Vestweber**
  **34330 Gilserberg 7 (DE)**
- **Holger Heil**
  **64285 Darmstadt (DE)**

(54) **Organische Elektrolumineszenzvorrichtung**

(57) Die vorliegende Erfindung betrifft die Verbesserung organischer elektronischer Vorrichtungen, insbesondere Elektrolumineszenzvorrichtungen, indem Verbindungen verwendet werden, die mehrere Isomere aufweisen können, wobei eines dieser Isomere im Überschuss vorliegt.

EP 1 655 359 A1

## Beschreibung

In einer Reihe Verschiedenartiger Anwendungen, die im weitesten Sinne der Elektronikindustrie zugerechnet werden können, ist der Einsatz organischer Halbleiter als funktionelle Materialien seit geraumer Zeit Realität bzw. wird in naher Zukunft erwartet. So finden bereits seit etlichen Jahren organische Ladungstransportmaterialien (i. d. R. Lochtransporter auf Triarylaminbasis) Verwendung in Kopiergeräten. Die Entwicklung organischer Transistoren (O-TFTs, O-FETs), organischer integrierter Schaltungen (O-ICs) und organischer Solarzellen (O-SCs) ist im Forschungsstadium schon sehr weit gediehen, so dass eine Markteinführung innerhalb der nächsten Jahre erwartet werden kann. Bei den organischen Elektrolumineszenzvorrichtungen (OLEDs) ist die Markteinführung bereits erfolgt, wie beispielsweise die Autoradios der Firma Pioneer oder eine Digitalkamera der Firma Kodak mit "organischem Display" belegen. Auch bei den polymeren lichtemittierenden Dioden (PLEDs) sind erste Produkte in Form einer kleinen Anzeige in einem Hasierapparat und einem Mobiltelefon der Firma Philips N. V. am Markt erhältlich.

Allerdings zeigen diese Vorrichtungen immer noch erhebliche Probleme, die einer dringenden Verbesserung bedürfen:

1. Die operative Lebensdauer ist insbesondere bei blauer Emission immer noch gering, so dass bis dato nur einfache Anwendungen kommerziell realisiert werden konnten.
2. Es werden teilweise Mischungen isomerer Verbindungen verwendet, die unterschiedliche physikalische Eigenschaften (Glasübergangtemperatur, Glasbildungseigenschaften, Absorption, Photolumineszenz) aufweisen können. Da diese Stereoisomeren teilweise auch bei der Verarbeitungstemperatur unterschiedliche Dampfdrücke aufweisen, ist keine einheitliche, reproduzierbare Herstellung der organischen elektronischen Vorrichtung möglich. Dieser Sachverhalt wurde in der bisherigen Literatur nicht als Problem erkannt, führt jedoch zu nicht reproduzierbaren Ergebnissen und damit zu erheblichen Störungen bei der Herstellung und beim Betrieb der organischen elektronischen Vorrichtungen.
3. Die verwendeten Verbindungen sind teilweise nur schwer in gängigen organischen Lösemitteln löslich, was ihre Reinigung bei der Synthese, aber auch die Reinigung der Anlagen bei der Herstellung der organischen elektronischen Vorrichtungen erschwert.

Hier wäre es deshalb wünschenswert, Verbindungen zur Verfügung zu haben, die die oben genannten Schwachpunkte nicht aufweisen und die verbesserte Eigenschaften in den organischen elektronischen Vorrichtungen zeigen.

Als nächstliegender Stand der Technik kann die Verwendung verschiedener kondensierter Aromaten, wie z. B. Anthracen- oder Pyrenderivate, als Host-Material insbesondere für blau emittierende Elektrolumineszenzvorrichtungen genannt werden.
Als Host-Material gemäß dem Stand der Technik ist beispielsweise 9,10-Bis(2-naphthyl)anthracen (US 5935721) bekannt. Weitere Anthracen-Derivate, die sich als Host-Materialien eignen, sind beispielsweise in WO 01/076323, in WO 01/021729, in WO 04/013073, in WO 04/018588, in WO 03/087023 oder in WO 04/018587 beschrieben. Host-Materialien, basierend auf aryl-substituierten Pyrenen und Chrysenen, werden in WO 04/016575 beschrieben, wobei diese Anmeldung prinzipiell auch entsprechende Anthracen- und Phenanthren-Derivate mit umfasst. Die Verwendung von Anthracen-Derivaten als Lochblockiermaterial ist beispielsweise in US 2004/0161633 beschrieben. Auch in WO 03/095445, in CN 1362464 und in einigen anderen Anmeldungen und Publikationen werden beispielsweise 9,10-Bis(1-naphthyl)anthracen-Derivate für die Verwendung in OLEDs beschrieben. In keiner der oben genannten Beschreibungen wird jedoch auf das Problem der Isomerie eingegangen.
Viele der in diesen Beschreibungen aufgeführten Verbindungen zeigen Atropisomerie, also Stereoisomerie, die durch gehinderte Rotation um eine Einfachbindung zustande kommt, wie unten noch ausführlich beschrieben wird. Beispiele dafür sind die Verbindungen EM5, EM12, EM28, EM32, EM33, EM38, EM39 und EM 54 in WO 04/018588 und die Verbindungen AN23, AN24, AN33, AN34, AN35, AN36, AN55 und AN56 in WO 04/018587. In keiner dieser Beschreibungen wird dieses Problem erkannt, sondern die entsprechenden Verbindungen werden immer als planare Moleküle abgebildet, ohne auf die räumliche Struktur einzugehen. Offensichtlich wurden immer die Mischungen der Isomere für die Herstellung der elektronischen Vorrichtungen verwendet. Dadurch können die oben bereits angedeuteten Probleme auftreten: Die isomeren Formen, die in der Mischung vorliegen, können unterschiedliche physikalische Eigenschaften (Glasübergangstemperatur, Morphologie, optische und elektronische Eigenschaften, etc.) aufweisen. Da diese Isomeren teilweise auch bei unterschiedlichen Temperaturen sublimieren, ist damit insbesondere auch keine einheitliche, reproduzierbare Herstellung der organischen elektronischen Vorrichtungen möglich, da je nach Fortschreiten der Sublimation unterschiedliche Anteile der Isomeren angereichert werden. Dies kann, außer Unterschieden in den physikalischen Eigenschaften, auch zu unterschiedlicher Filmmorphologie führen; allemal ist die Reproduzierbarkeit eingeschränkt.

Der oben aufgeführte Stand der Technik belegt, dass das Host-Material eine entscheidende Rolle bei den Eigenschaften organischer Elektrolumineszenzvorrichtungen spielt. Analoges gilt für die Materialien in anderen Funktionen bzw. in anderen Schichten und auch für die Materialien in anderen organischen elektronischen Vorrichtungen. Daher sollte es möglich sein, durch weitere Optimierung der Materialien auch die Eigenschaften der organischen elektronischen Vorrichtungen weiter zu verbessern. Es besteht also weiterhin Bedarf an Materialien, insbesondere Host-Materialien für blau emittierende OLEDs, die in organischen elektronischen Vorrichtungen zu guten Effizienzen und gleichzeitig zu hohen Lebensdauern führen und die bei der Herstellung und beim Betrieb der Vorrichtungen zu reproduzierbaren Ergebnissen führen. Es wurde nun überraschend gefunden, dass organische elektronische Vorrichtungen, die atropisomere Verbindungen enthalten, welche zur Bildung von Diastereomeren befähigt sind, und die eines der möglichen Stereoisomere im Überschuss enthalten, deutliche Verbesserungen gegenüber dem Stand der Technik aufweisen. Mit diesen angereicherten bzw. isolierten Materialien ist eine Steigerung der Effizienz und der Lebensdauer in der organischen elektronischen Vorrichtung im Vergleich zur entsprechenden Isomerenmischung möglich. Insbesondere ist aber mit diesen Materialien die besser reproduzierbare Herstellung organischer elektronischer Vorrichtungen möglich, da nicht eine statistische Materialmischung verwendet wird, deren einzelne Komponenten unterschiedliche Sublimationstemperaturen bzw. unterschiedliche weitere physikalische Eigenschaften aufweisen können und deren Zusammensetzung während des Aufdampfprozesses variiert, sondern Materialien, die stark mit einzelnen Isomeren angereichert sind, bzw. isolierte Isomere.

N.-X. Hu *et al.* (*J. Am. Chem. Soc.* **1999,** *121,* 5097) beschreiben das Auftreten von Atropisomerie in N,N-Dinaphth-1-yl-substituiertem Indolocarbazol, welches als Lochtransportmaterial getestet wurde. Dabei entstanden bei der Synthese die beiden Stereoisomere (wovon eines als Racemat vorliegt) in einem Verhältnis von ca. 1 : 1, wie für eine statistische Reaktion zu erwarten ist. Die Isolierung der Einzelkomponenten war den Autoren nicht möglich, jedoch eine Anreicherung eines der beiden Isomere. Es wurde nur die 1 : 1 Isomerenmischung in organischen Elektrolumineszenzvorrichtungen getestet, jedoch nicht die angereicherte Form eines Isomers, so dass hier keine Aussage über die Unterschiede bei Verwendung eines angereicherten Isomers getroffen werden kann. Ohne dies durch experimentelle Ergebnisse zu belegen, vermuten die Autoren, dass die Verwendung dieser Isomerenmischung (im Gegensatz zu einem isolierten Isomer) zu Vorteilen führt, da dadurch die Kristallisation verhindert würde und die Verbindungen ein stabiles Glas bilden könnten.

Gegenstand der Erfindung sind organische elektronische Vorrichtungen, enthaltend Kathode, Anode und mindestens eine Schicht, enthaltend mindestens eine organische Verbindung, die Atropisomerie aufweist und dadurch zur Bildung von Diastereomeren befähigt ist, dadurch gekennzeichnet, dass ein Atropisomerenüberschuss von mindestens 10 % vorliegt.

Die organischen elektronischen Vorrichtungen sind bevorzugt ausgewählt aus der Gruppe elektronischer Vorrichtungen, bestehend aus organischen und polymeren Leuchtdioden (OLEDs, PLEDs), organischen Feld-Effekt-Transistoren (O-FETs), organischen Dünnfilmtransistoren (O-TFTs), organischen integrierten Schaltungen (O-ICs), organischen Solarzellen (O-SCs), organischen Feld-Quench-Devices (O-FQDs) und organischen Laserdioden (O-Laser). Bevorzugt sind organische und polymere Leuchtdioden.

Je nach Struktur der Verbindung, die Atropisomerie aufweist, kann diese Verbindung in verschiedenen Funktionen in der organischen elektronischen Vorrichtung verwendet werden, so als Host-Material für Dotanden, die aus dem Singulett- oder aus dem Triplett-Zustand Licht emittieren können, als Dotand, als Lochtransportmaterial, als Elektronentransportmaterial oder als Lochblockiermaterial. Dabei unterscheidet sich die Verwendung des Materials mit Atropisomerenüberschuss nicht von der üblichen Verwendung, die mit Isomerenmischungen des jeweiligen Materials bekannt ist. Besonders viele Verbindungen, die Atropisomerie zeigen, sind bislang bei den Host-Materialien für Singulett-Emitter bekannt. In einer bevorzugten Ausführungsform der Erfindung wird daher als Host-Material eine Verbindung verwendet, die Atropisomerie, wie oben beschrieben, zeigt und die einen Atropisomerenüberschuss von mindestens 10 % aufweist. Dies gilt in erster Linie für organische Elektrolumineszenzvorrichtungen. In anderen Vorrichtungen können auch andere Verwendungen der Materialien bevorzugt sein, so beispielsweise Ladungstransportmaterialien in organischen Feld-Effekt-Transistoren oder organischen Dünnfilmtransistoren.

Die organische elektronische Vorrichtung enthält eine oder mehrere organische Schichten, von denen mindestens eine Schicht mindestens eine Verbindung enthält, wie oben beschrieben. Wenn es sich um eine organische Elektrolumineszenzvorrichtung handelt, ist mindestens eine organische Schicht eine Emissionsschicht. Bei organischen Transistoren ist mindestens eine organische Schicht eine Ladungstransportschicht. In organischen Elektrolumineszenzvorrichtungen können außer der emittierenden Schicht noch weitere Schichten vorhanden sein. Diese können beispielsweise sein:

Lochinjektionsschicht, Lochtransportschicht, Lochblockierschicht, Elektronentransportschicht und/oder Elektroneninjektionsschicht. Es sei aber an dieser Stelle darauf hingewiesen, dass nicht notwendigerweise jede dieser Schichten vorhanden sein muss.

Erfindungsgemäß wird in der organischen elektronischen Vorrichtung mindestens eine organische Verbindung verwendet, die Atropisomerie aufweist und dadurch zur Bildung von Diastereomeren befähigt ist, wobei ein Atropisomerenüberschuss von mindestens 10 % vorliegt.

Unter Isomerie wird allgemein die Erscheinung bezeichnet, dass Verbindungen aus der gleichen Anzahl gleicher

Atome sich hinsichtlich ihrer Anordnung unterscheiden können. Isomere sind somit chemische Verbindungen mit gleichen Brutto-, jedoch unterschiedlichen Strukturformeln. Für diese Anmeldung ist die Stereoisomerie (unterschiedliche räumliche Anordnung bei gleicher Verknüpfung) von Bedeutung, die im Zusammenhang mit der oben genannten und unten näher ausgeführten Atropisomerie zu Enantiomeren und/oder zu Diastereomeren führen kann.

Als enantiomer werden nach IUPAC-Regel E-4.4 solche Moleküle (Stereoisomere) oder chirale Gruppen bezeichnet, die sich zueinander wie Bild und Spiegelbild verhalten und die nicht miteinander zur Deckung zu bringen sind. Enantiomere unterscheiden sich nicht in ihren gewöhnlichen physikalischen Eigenschaften, d. h. sie haben den gleichen Dampfdruck, die gleiche Löslichkeit, die gleichen spektroskopischen Daten, usw.. Lediglich die chiroptischen Eigenschaften (Wechselwirkung mit polarisiertem Licht) sind unterschiedlich.

Als diastereomer werden nach IUPAC-Regel E-4.6 solche Moleküle (Stereoisomere) bezeichnet, die die gleiche Verknüpfung (Konstitution) aufweisen, sich aber nicht wie Bild und Spiegelbild zueinander verhalten. Diastereomere lassen sich durch keine Symmetrieoperation ineinander überführen und können sowohl chiral als auch achiral sein. Im Gegensatz zu Enantiomeren unterscheiden sich Diastereomere in ihren physikalischen und chemischen Eigenschaften.

Unter Konformation versteht man die genaue räumliche Anordnung von Atomen oder Atomgruppen eines Molekül definierter Verknüpfung. Verschiedene Konformere werden durch Rotation um Einfachbindungen erzeugt und lassen sich nicht zur Deckung bringen. Entsprechen die so erzeugten Anordnungen einem Energieminimum, so redet man von Konformationsisomeren oder Konferomeren.

Unter Atropisomerie (Definition gemäß Römpp Lexikon Chemie - Version 2.0, Stuttgart/New York: Georg Thieme Verlag 1999) wird eine Form der Stereoisomerie verstanden, bei der die Stereoisomerie des Moleküls durch Behinderung der freien Rotation um eine Einfachbindung, also durch sterische Hinderung von Molekülteilen, hervorgerufen wird (also formal Konformere mit gehinderter Rotation). Je nach Anzahl der Einfachbindungen, um die die Rotation gehindert ist, und je nach vorhandenen Substituenten können die Verbindungen chiral oder achiral sein, bzw. sie sind diastereomer zueinander. Bei Atropisomeren stellt sich in der Regel ein Gleichgewicht ein, wenn durch Temperaturerhöhung die innere Beweglichkeit im Molekül vergrößert wird, so dass die Energiebarriere für die gegenseitige Umwandlung überwunden wird. Dagegen wird bei Raumtemperatur, wenn die Energiebarriere ausreichend groß ist, keine Umwandlung der Isomere beobachtet. Isolierbar gelten im Allgemeinen Atropisomere, wenn die Energiebarriere bei Raumtemperatur bei etwa 80 kJ/mol oder mehr liegt, wie beispielsweise bei Biphenyl-Derivaten mit ausreichend großen Substituenten in 2-Position (ortho-Stellung). Da jede stereogene Achse (rotationsgehinderte Einfachbindung) in atropisomeren Verbindungen in einer oder der anderen von zwei möglichen Konformationen auftreten kann, gibt es $2^n$ Stereoisomere (Diastereomere und Enantiomere) für n nichtäquivalente Achsen. Die Anzahl der Stereoisomere kann jedoch auch weniger als $2^n$ betragen, wenn durch intrinsische Symmetrieelemente z. B. ein Stereoisomer achiral ist oder eine Achse seine Stereogenität verliert, d. h. dass bei Rotation um diese Achse kein neues Stereoisomer gebildet wird.

Die oben gemachten Ausführungen zur Symmetrie haben auf die in dieser Erfindung relevante Atropisomerie verschiedene Auswirkungen:

Wenn Atropisomerie um nur eine Einfachbindung vorliegt, so können je nach Substitution gegebenenfalls Enantiomere, jedoch keine Diastereomere auftreten. Da diese, wie oben ausgeführt, identische physikalische Eigenschaften haben und außerdem häufig schwierig zu trennen sind, betrifft diese Erfindung nur Verbindungen mit zwei oder mehr rotationsgehinderten Einfachbindungen, die zur Bildung von Diastereomeren befähigt sind, wobei der Molekülteil zwischen den beiden rotationsgehinderten Einfachbindungen keine weiteren Einfachbindungen aufweist, um die eine freie Rotation möglich ist.

Wenn zwei rotationsgehinderte Einfachbindungen vorliegen, können je nach Aufbau und Substitutionsmuster der einzelnen Molekülteile zwischen 1 und 4 Isomere vorliegen. Dies sei schematisch an einem Molekül des allgemeinen Aufbaus A-B-C dargestellt (Schema 1): Wenn die Molekülteile A und C jeweils gleich und symmetrisch aufgebaut sind, ist auch bei gehinderter Rotation um die Bindungen nur ein einziges Isomer möglich (Schema 1 a), da sich die Konformationen nicht unterscheiden und alle Konformere miteinander zur Deckung zu bringen sind. Dies gilt auch, wenn beispielsweise nur der Molekülteil B oder nur einer der Molekülteile A oder C substituiert sind. Sind dagegen die beiden Molekülteile A und C substituiert bzw. unsymmetrisch aufgebaut, wobei A und C gleich oder verschieden sein können, so ergeben sich zwei Atropisomere, die zueinander diastereomer sind (Schema 1 b). Diese beiden Atropisomere werden auch als syn- und anti-Form bezeichnet. Jedes dieser beiden Atropisomere ist achiral (also deckungsgleich zu seinem Spiegelbild), da jedes mindestens eine Spiegelebene im Molekül aufweist. Sind nun zusätzlich zu gleichen Substituenten an A und C noch ein oder mehrere Substituenten an B vorhanden, die die Einheit B unsymmetrisch machen, so existiert weiterhin nur eine syn-Form, während die anti-Form in zwei Enantiomere zerfällt (Schema 1 c). Sind statt gleicher Substituenten an A und C unterschiedliche Substituenten vorhanden, so entstehen vier Atropisomere, die zueinander diastereomer bzw. enantiomer sind (Schema 1d). In diesem Fall zerfällt sowohl die syn-Form, wie auch die anti-Form in jeweils zwei Enantiomere, wobei jede der beiden syn-Formen zu jeder der beiden anti-Formen diastereomer ist.

Vergleichbare Überlegungen lassen sich anstellen, wenn mehr als zwei Einfachbindungen mit gehinderter Rotation vorhanden sind, wodurch entsprechend mehr Atropisomere entstehen können. Ähnliche Ausführungen können auch der Literatur entnommen werden (bspw. J. Gawronski, K. Kacprzak, *Chirality* **2002**, 14, 689). Die genauen Punktgruppen

der entsprechenden Verbindungen hängen von der exakten Geometrie der Moleküle ab. So sind die in Schema 1 angegebenen Punktgruppen nur für die dort abgebildeten schematischen Zeichnungen zu verstehen. Genauere Überlegungen dazu finden sich ebenfalls in der oben zitierten Literatur.

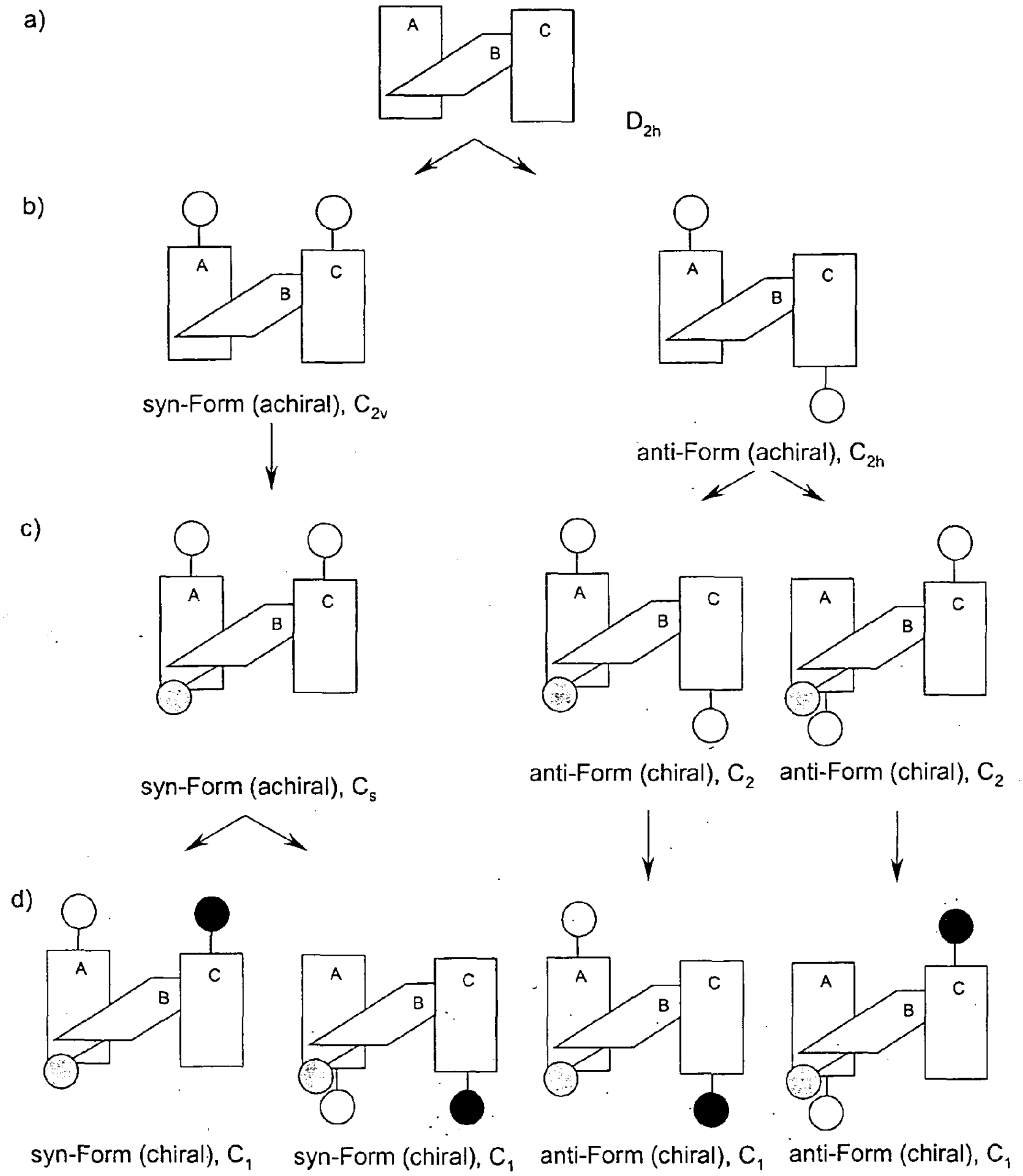


**Schema 1**: Schematische Darstellung der verschiedenen möglichen Atropisomere, abhängig von der Substitution des Moleküls; dabei liegt zwischen den Molekülteilen A, B und C jeweils eine Einfachbindung mit gehinderter Rotation vor.

Die Definition des Atropisomerenüberschuss erfolgt in Analogie zu der in der organischen Chemie gebräuchlichen Definition des Enantiomeren- bzw. Diastereomeren-Überschuss. Unter Atropisomerenüberschuss im Sinne dieser Erfindung soll verstanden werden:

$$\text{Atropisomerenüberschuss [\%]} = [\text{molarer Anteil (Überschuss-Isomer)} - \text{molarer Anteil (Unterschuss-Isomer)}] \times 100$$

Dies bedeutet, dass ein Atropisomerenüberschuss von 10 % einer Verteilung (bei zwei Isomeren) von 55 : 45 entspricht. Einige weitere Atropisomerenüberschüsse und die entsprechenden molaren Verteilungen sind in Tabelle 1 angegeben:

Tabelle 1: Zusammenhang zwischen Atropisomerenüberschuss und molarer Verteilung der Isomere

| Atropisomerenüberschuss | molare Verteilung |
|---|---|
| 10 % | 55 : 45 |
| 20 % | 60 : 40 |
| 50 % | 75 : 25 |
| 90 % | 95 : 5 |
| 95 % | 97.5 : 2.5 |
| 99 % | 99.5 : 0.5 |

Ein Spezialfall kann sich ergeben, wenn mehr als zwei Atropisomere möglich sind, beispielsweise durch Bildung von Enantiomeren, wie in Schema 1 c oder 1 d beschrieben, oder auch, wenn durch Vorliegen von mehr als zwei Einfachbindungen mit gehinderter Rotation mehr als zwei Diastereomere vorliegen können. In diesen Fällen soll der Atropisomerenüberschuss im Sinne dieser Erfindung folgendermaßen definiert sein:
Bei Vorliegen von Diastereomeren und Enantiomeren (wie in Schema 1 c und 1 d) soll als Atropisomerenüberschuss der entsprechende Diastereomerenüberschuss (und nicht der Enantiomerenüberschuss) bezeichnet werden, unabhängig davon, ob das Diastereomer noch in Enantiomere zerfällt oder nicht. Dabei ist es gleichermaßen zulässig, dass das angereicherte Diastereomer als Racemat (also beide
Enantiomere zu gleichen Anteilen) vorliegt oder dass ein Enantiomer im Überschuss bzw. in Reinform vorliegt.
Bei Vorliegen von mehr als zwei Diastereomeren soll der Atropisomerenüberschuss analog zu oben bestimmt werden, wobei alle Unterschuss-Atropisomere gemeinsam als eine Gruppe betrachtet werden sollen. Hier berechnet sich der Atropisomerenüberschuss also folgendermaßen:

$$\text{Atropisomerenüberschuss [\%]} = [\text{molarer Anteil (Überschuss-Isomer)} - \Sigma\ (\text{molarer Anteil (Unterschuss-Isomere)}) / \text{Anzahl (Unterschuss-Isomere)}] \times 100$$

Der Atropisomerenüberschuss kann mit üblichen chemischen Analysemethoden bestimmt werden, beispielsweise durch HPLC oder durch $^1$H-NMR-Spektroskopie, da es sich um Diastereomere mit unterschiedlichen physikalischen Eigenschaften (unterschiedliche Retentionszeiten in der HPLC, unterschiedliche chemische Verschiebung im NMR) handelt. Eine bevorzugte Methode ist die Bestimmung durch HPLC.

Um stabile Atropisomere isolieren zu können, muss die Aktivierungsenergie für die Rotation um die entsprechenden Einfachbindungen mindestens ca. 80 kJ/mol betragen. Die oben verwendete Bezeichnung "Einfachbindung mit gehinderter Rotation" soll sich also auf eine Aktivierungsenergie der Rotation um diese Einfachbindung von mindestens 80 kJ/mol beziehen. Diese Aktivierungsenergie lässt sich beispielsweise durch Temperatur-abhängige NMR-Messung bestimmen. Da die Verbindungen jedoch auch höhere Temperaturen aushalten müssen (beispielsweise bei einer Umkristallisation bzw. Sublimation, aber auch in der organischen elektronischen Vorrichtung), ist es bevorzugt, wenn die Aktivierungsenergie für die Rotation um die Einfachbindungen mindestens 100 kJ/mol beträgt, besonders bevorzugt mindestens 120 kJ/mol, insbesondere mindestens 140 kJ/mol. Die Aktivierungsenergie für die Rotation um die Einfachbindung lässt sich durch den genauen Aufbau der Verbindungen und insbesondere durch die Substitution steuern.

Es ist bevorzugt, wenn die Atropisomerie zwischen zwei $sp^2$-Zentren erzeugt wird und nicht beispielsweise zwischen einem $sp^2$- und einem $sp^3$-Zentrum. Ebenso ist es bevorzugt, wenn die Atropisomerie durch gehinderte Rotation um C-C-Einfachbindungen erzeugt wird und nicht beispielsweise durch gehinderte Rotation um C-N-Einfachbindungen.

Wie oben beschrieben, ist Gegenstand der Erfindung die Verwendung eines Atropisomerenüberschuss von mindestens 10 %. Bevorzugt ist jedoch ein größerer Atropisomerenüberschuss von mindestens 20 %, besonders bevorzugt von mindestens 50 %, ganz besonders bevorzugt von mindestens 70 %, mindestens 90 %, mindestens 95 % bzw. mindestens 99 %. Größere Atropisomerenüberschüsse sind bevorzugt, da dadurch eine bessere Reproduzierbarkeit gewährleistet ist.

In einem bevorzugten Aspekt der vorliegenden Erfindung weist die Verbindung genau zwei Einfachbindungen mit gehinderter Rotation auf, und das überwiegend vorliegende Atropisomer ist das syn-Isomer.

In einem weiteren bevorzugten Aspekt der vorliegenden Erfindung weist die Verbindung genau zwei Einfachbindungen mit gehinderter Rotation auf, und das überwiegend vorliegende Atropisomer ist das anti-Isomer.

In nochmals einem weiteren bevorzugten Aspekt der vorliegenden Erfindung werden Verbindungen verwendet, die genau drei Einfachbindungen mit gehinderter Rotation aufweisen und daher mehr als die in Schema 1 aufgeführten vier Atropisomere aufweisen können. Dabei können diese Einfachbindungen, um die Atropisomerie vorliegt, entweder linear oder verzweigt angeordnet sein.

In nochmals einem weiteren bevorzugten Aspekt der vorliegenden Erfindung werden Verbindungen verwendet, die genau vier Einfachbindungen mit gehinderter Rotation aufweisen und daher nochmal mehr Atropisomere aufweisen können. Dabei können diese Einfachbindungen, um die Atropisomerie vorliegt, entweder linear oder verzweigt angeordnet sein.

In nochmals einem weiteren bevorzugten Aspekt der vorliegenden Erfindung werden Verbindungen verwendet, die mehr als vier Einfachbindungen mit gehinderter Rotation aufweisen und daher nochmal mehr Atropisomere aufweisen können. Dabei können diese Einfachbindungen, um die Atropisomerie vorliegt, entweder linear oder verzweigt angeordnet sein.

Die Verbindung, die Atropisomerie aufweist, ist bevorzugt eine Verbindung der Formel (1),

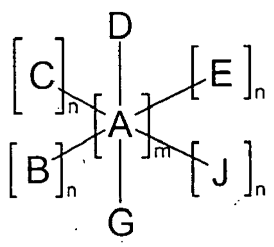

Formel (1)

wobei für die Symbole gilt:

| | |
|---|---|
| A | ist bei jedem Auftreten gleich oder verschieden ein aromatisches oder heteroaromatisches Ringsystem mit 2 bis 40 C-Atomen, das durch R substituiert oder unsubstituiert sein kann, mit der Maßgabe, dass in allen ortho-Positionen zur Verknüpfung zu B, C, D, E, G bzw. J (bzw. auch zur Verknüpfung zu anderen A, falls m > 1) nicht direkt ein Wasserstoffatom gebunden ist, sondern eine Gruppe R oder eine Gruppe B, C, D, E, G bzw. J, bzw. dass diese Position blockiert ist, wenn A ein kondensiertes aromatisches Ringsystem darstellt; und weiterhin mit der Maßgabe, dass im aromatischen oder heteroaromatischen Ringsystem keine Einfachbindung vorhanden ist, um die freie Rotation möglich ist; |
| B, C, D, E, G, J | ist bei jedem Auftreten gleich oder verschieden ein aromatisches oder heteroaromatisches Ringsystem mit 2 bis 40 C-Atomen, das unsubstituiert oder durch einen oder mehrere Reste R substituiert sein kann, mit der Maßgabe, dass in mindestens einer ortho-Position zur Verknüpfung zu A nicht direkt ein Wasserstoffatom gebunden ist, sondern eine Gruppe R, bzw. dass diese Position blockiert ist, wenn B, C, D, E, G bzw. J ein kondensiertes aromatisches Ringsystem darstellen; |
| R | ist bei jedem Auftreten gleich oder verschieden F, Cl, Br, I, eine geradkettige, verzweigte oder cyclische Alkyl- oder Alkoxykette mit 1 bis 40 C-Atomen, die durch $R^1$ substituiert sein kann, in der auch ein oder mehrere nicht benachbarte C-Atome durch N-$R^1$, O, S, O-CO-O, CO-O, -$CR^1$=$CR^1$- oder -C≡C- ersetzt sein können und in der auch ein oder mehrere H-Atome durch F, Cl, Br, I oder CN ersetzt sein können, oder ein aromatisches oder heteroaromatisches Ringsystem mit 2 bis 40 C-Atomen, welches auch durch einen oder mehrere Reste $R^1$ substituiert sein kann, oder eine Kombination aus zwei bis fünf dieser Systeme; dabei können zwei oder mehrere Reste R miteinander auch ein weiteres mono- oder polycyclisches, aliphatisches oder aromatisches Ringsystem bilden; |
| $R^1$ | ist bei jedem Auftreten gleich oder verschieden H oder ein aliphatischer oder aromatischer Kohlenwasserstoffrest mit 1 bis 20 C-Atomen; |
| n | ist bei jedem Auftreten gleich oder verschieden 0 oder 1; |
| m | ist bei jedem Auftreten gleich oder verschieden 1, 2, 3, 4 oder 5, bevorzugt 1, 2 oder 3, besonders bevorzugt 1 oder 2, ganz besonders bevorzugt 1. |

Im Rahmen der vorliegenden Erfindung werden unter einer $C_1$- bis $C_{40}$-Alkylgruppe, in der auch einzelne H-Atome oder $CH_2$-Gruppen durch die oben genannten Gruppen substituiert sein können, besonders bevorzugt die Reste

Methyl, Ethyl, n-Propyl, i-Propyl, n-Butyl, i-Butyl, s-Butyl, t-Butyl, n-Pentyl, s-Pentyl, Cyclopentyl, n-Hexyl, Cyclohexyl, n-Octyl, Cyclooctyl, 2-Ethylhexyl, Trifluormethyl, Pentafluorethyl, 2,2,2-Trifluorethyl, Ethenyl, Propenyl, Butenyl, Pentenyl, Cyclopentenyl, Hexenyl, Cyclohexenyl, Octenyl, Cyclooctenyl, Ethinyl, Propinyl, Butinyl, Pentinyl, Hexinyl oder Octinyl verstanden. Unter einer $C_1$- bis $C_{40}$-Alkoxygruppe werden besonders bevorzugt Methoxy, Ethoxy, n-Propoxy, i-Propoxy, n-Butoxy, i-Butoxy, s-Butoxy oder t-Butoxy verstanden. Unter einem $C_4$-$C_{40}$ aromatischen oder heteroaromatischen Ringsystem werden besonders bevorzugt Phenyl, Biphenyl, Naphthyl, Anthracenyl, Triphenylenyl, [1,1';3', 1"]-Terphenyl-2'-yl, Binaphthyl, Phenanthrenyl, Fluorenyl, Spirobifluorenyl, Dihydrophenanthrenyl, Dihydropyrenyl, Tetrahydropyrenyl, cis- oder trans-Indenofluorenyl, 2-Pyridyl, 3-Pyridyl, 4-Pyridyl, 2-Pyrimidinyl, 4-Pyrimidinyl, 5-Pyrimidinyl, 2-Pyrazinyl, 3-Pyridazinyl, 4-Pyridazinyl, Chinolinyl, Isochinolinyl, Chinoxalinyl, Acridinyl, Benzochinolinyl, Benzoisochinolinyl, 2-Thienyl, 3-Thienyl, 2-Furanyl, 3-Furanyl, 2-Pyrrolyl, 3-Pyrrolyl, Indolyl, Isoindolyl, Pentafluorophenyl, Tetrafluorophenyl, 3,5-Bistrifluoromethylphenyl, Heptafluoronaphthyl, o-Tolyl, m-Tolyl, p-Tolyl, 2,6-Dimethylphenyl, 2,6-Diethylphenyl, 2,6-Di-i-propylphenyl, 2,6-Di-t-butylphenyl, o-t-Butylphenyl, m-t-Butylphenyl oder p-t-Butylphenyl verstanden, die auch durch die oben genannten Reste R substituiert sein können.

In einer bevorzugten Ausführungsform der Erfindung ist an A in allen ortho-Positionen zur Verknüpfung zu B, C, D, E, G und J mindestens ein Kohlenstoffatom gebunden. Dieses kann entweder in einem kondensierten Ringsystem (direkt an der aromatischen bzw. heteroaromatischen Einheit A) sein, oder es kann als Substituent R an A gebunden sein. In weiteren bevorzugten Ausführungsform der Erfindung ist an B, C, D, E, G und J in jeweils mindestens einer ortho-Position zur Verknüpfung zu A mindestens ein Kohlenstoffatom gebunden. Dieses kann entweder in einem kondensierten Ringsystem (direkt in der aromatischen bzw. heteroaromatischen Einheit B, C, D, E, G bzw. J) vorhanden sein, oder es kann als Substituent R jeweils an B, C, D, E, G bzw. J gebunden sein.

Insbesondere bevorzugt sind die noch stabileren Atropisomere, die erhalten werden können, wenn in ortho-Position zur jeweiligen Verknüpfungen größere Gruppen vorhanden sind, bevorzugt mit mindestens zwei C-Atomen.

In einer bevorzugten Ausführungsform der Erfindung ist mindestens eine der Gruppen A, D und/oder G (und/oder gegebenenfalls B, C, E und J) ein kondensiertes aromatisches Ringsystem. In einer Ausführungsform der Erfindung ist A ein kondensiertes aromatisches Ringsystem. In einer weiteren Ausführungsform sind D und G (und gegebenenfalls auch B, C, E und/oder J) kondensierte aromatische Ringsysteme oder ortho-Biphenyl. In einer besonders bevorzugten Ausführungsform der Erfindung sind A und D und G (und wenn vorhanden auch B, C, E und J) jeweils kondensierte aromatische Ringsysteme. In einer weiteren bevorzugten Ausführungsform der Erfindung ist mindestens eine der Gruppen A, D und/oder G (und/oder gegebenenfalls B, C, E und/oder J) ein kondensiertes heteroaromatisches Ringsystem, oder die Gruppen D und/oder G (und/oder gegebenenfalls B, C, E und/oder J) stellen ein ortho-Biphenyl-System dar.

Unter einem aromatischen oder heteroaromatischen Ringsystem im Sinne dieser Erfindung soll ein System verstanden werden, das nicht notwendigerweise nur aromatische bzw. heteroaromatische Gruppen enthält, sondern in dem auch mehrere aromatische oder heteroaromatische Gruppen durch eine kurze, nicht aromatische Einheit (weniger als 10 % der von H verschiedenen Atome, bevorzugt weniger als 5 % der von H verschiedenen Atome), wie z. B. ein $sp^3$-hybridisiertes C-, N- oder O-Atom, unterbrochen sein können. So sollen also beispielsweise auch Systeme wie 9,9'-Spirobifluoren, 9,9-Diarylfluoren, Triarylamin, etc. als aromatische Ringsysteme im Sinne dieser Erfindung verstanden werden. Dabei kann das aromatische oder heteroaromatische Ringsystem auch ein kondensiertes System im Sinne der folgenden Definition sein.

Unter kondensierten aromatischen bzw. heteroaromatischen Ringsystemen im Sinne dieser Erfindung werden Ringsysteme verstanden, in denen mindestens zwei Ringe, von denen mindestens einer aromatisch oder heteroaromatisch ist, miteinander "verschmolzen", d. h. durch Anellierung einander ankondensiert sind, also mindestens eine gemeinsame Kante und gegebenenfalls auch ein gemeinsames aromatisches $\pi$-Elektronensystem aufweisen. Diese Ringsysteme können durch R substituiert oder unsubstituiert sein; ebenso können sie vollständig aromatisch sein oder sie können auch teilweise gesättigt sein. So sind beispielsweise Systeme wie Naphthalin, Tetrahydronaphthalin, Anthracen, Phenanthren, Dihydrophenanthren, Pyren, Fluoren, Spirobifluoren, Carbazol, etc. als kondensierte aromatische Ringsysteme zu sehen, während beispielsweise Biphenyl kein kondensiertes aromatisches Ringsystem darstellt, da dort keine gemeinsame Kante zwischen den beiden Ringsystemen vorliegt.

Bevorzugt enthalten die kondensierten aromatischen Ringsysteme zwischen zwei und acht aromatische, heteroaromatische oder andere cyclische Einheiten, insbesondere aromatische oder heteroaromatische Einheiten, die jeweils über eine oder mehrere gemeinsame Kanten einander ankondensiert sind und dadurch gegebenenfalls ein gemeinsames aromatisches System ausbilden und die durch R substituiert oder unsubstituiert sein können.

Besonders bevorzugt enthalten die kondensierten aromatischen Ringsysteme zwischen zwei und sechs heteroaromatische oder bevorzugt aromatische Einheiten, insbesondere zwischen zwei und vier aromatische Einheiten, die jeweils über eine oder mehrere gemeinsame Kanten einander ankondensiert sind und dadurch ein gemeinsames aromatisches System ausbilden und die durch R substituiert oder unsubstituiert sein können.

Ganz besonders bevorzugt sind die einander ankondensierten aromatischen und heteroaromatischen Einheiten ausgewählt aus Benzol, Pyridin, Pyrimidin, Pyrazin, Pyridazin, Pyrrol und Thiophen, die durch R substituiert oder unsubstituiert sein können, insbesondere Benzol und Pyridin.

Die kondensierten aromatischen Ringsysteme sind bevorzugt ausgewählt aus der Gruppe bestehend aus Naphthalin, Anthracen, Phenanthren, Pyren, Naphthacen, Chrysen, Pentacen, Fluoren, 9,9'-Spirobifluoren, Chinolin, Isochinolin, Chinoxalin, Phenanthrolin, Perylen, Triphenylen, Indenofluoren, Carbazol, Benzothiophen oder Dibenzothiophen, die gegebenenfalls durch R substituiert sein können. Besonders bevorzugt sind die kondensierten aromatischen Ringsysteme ausgewählt aus der Gruppe bestehend aus Naphthalin, Anthracen, Phenanthren, Pyren oder Perylen, die gegebenenfalls durch R substituiert sein können. Die Substitution mit R kann insbesondere sinnvoll sein, um gegebenenfalls die Aktivierungsenergie für die Rotation um die entsprechende Einfachbindung zu erhöhen und somit stabilere Isomere zu erhalten. Die Substitution kann weiterhin sinnvoll sein, um besser lösliche Verbindungen zu erhalten. Insbesondere kann die Substitution auch helfen, zwischen unterschiedlichen Atropisomeren zu differenzieren, da sich je nach Verbindung durch den Substituenten die Eigenschaften der beiden Isomere, beispielsweise die Löslichkeit und/ oder die Polarität, zu unterschiedlichen Anteilen ändert, wodurch die Auftrennung der beiden Isomere vereinfacht werden kann.

In einer besonders bevorzugten Ausführungsform der Erfindung steht das Symbol A für eine 9,10-verknüpfte Anthracen-Einheit. Diese weist durch die Art der Verknüpfung bereits ausreichend große Gruppen in ortho-Position zur Verknüpfung auf, so dass hier keine weiteren Substituenten an dieser Einheit zwingend nötig sind, um stabile Atropisomere zu ermöglichen. In einer weiteren bevorzugten Ausführungsform der Erfindung steht das Symbol A für eine Pyren-Einheit.

Beispiele für geeignete Verbindungen, die Atropisomere bilden, sind die in Beispiel 1 bis Beispiel 14 aufgezeigten Strukturen, wobei jeweils das Beispiel a die syn-Form und das Beispiel b die anti-Form zeigt und wobei sich jeweils beide (bzw. alle) möglichen Atropisomere in angereichter bzw. reiner Form für die Verwendung in organischen elektronischen Vorrichtungen eignen: Dabei deuten die dick abgebildeten Bindungen die Molekülteile an, die oberhalb der Ebene liegen, die durch die zentrale Einheit aufgespannt wird.

| | |
|---|---|
| 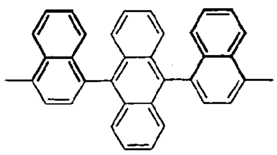 | 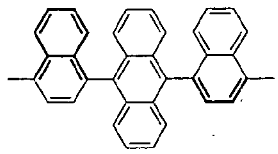 |
| Beispiel 1a (syn) | Beispiel 1b (anti) |

| | |
|---|---|
| 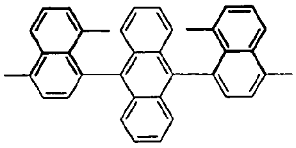 | 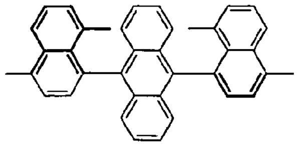 |
| Beispiel 2a (syn) | Beispiel 2b (anti) |
| 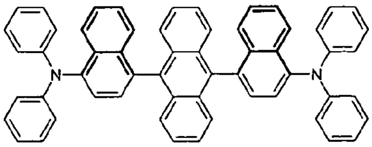 | 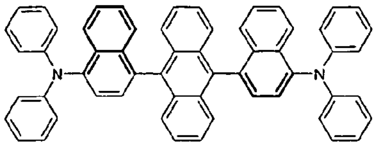 |
| Beispiel 3a (syn) | Beispiel 3b (anti) |
| 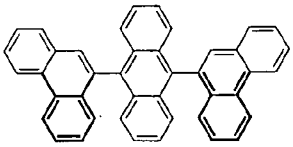 | 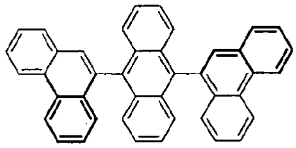 |
| Beispiel 4a (syn) | Beispiel 4b (anti) |
| 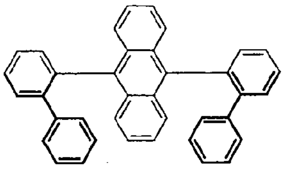 | 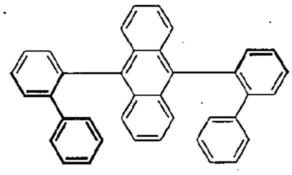 |
| Beispiel 5a (syn) | Beispiel 5b (anti) |
| 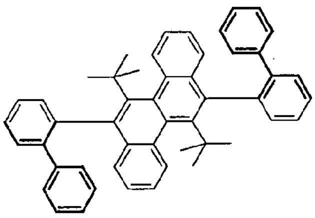 | 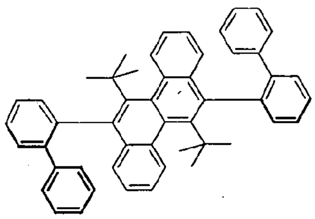 |
| Beispiel 6a (syn) | Beispiel 6b (anti) |
| 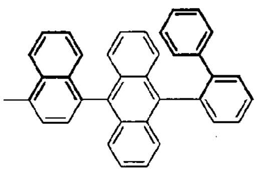 | 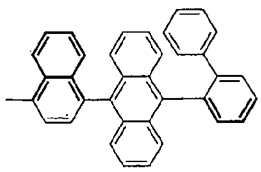 |
| Beispiel 7a (syn) | Beispiel 7b (anti) |
| 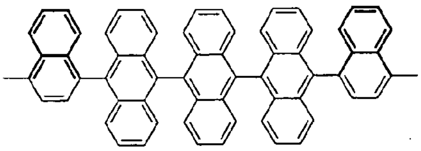 | 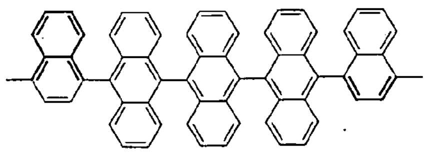 |
| Beispiel 8a (syn) | Beispiel 8b (anti) |

| | |
|---|---|
| 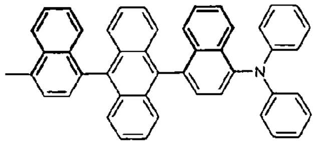 | 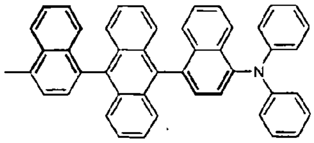 |
| Beispiel 9a (syn) | Beispiel 9b (anti) |
| 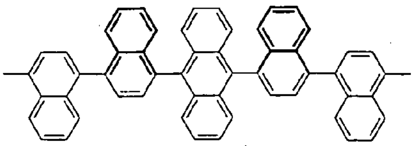 | 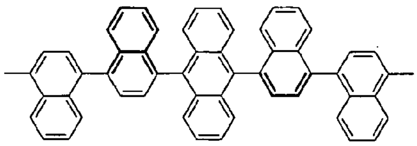 |
| Beispiel 10a (syn) | Beispiel 10b (anti) |
| 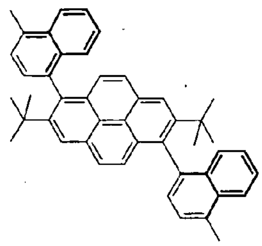 | 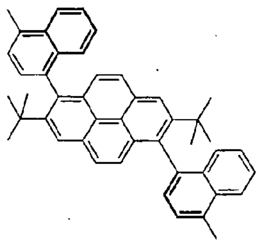 |
| Beispiel 11a (syn) | Beispiel 11b (anti) |
| 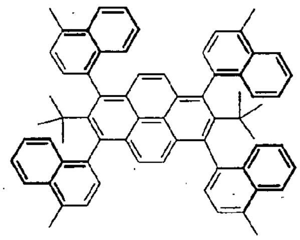 | 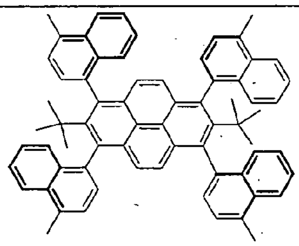 |
| Beispiel 12a (syn-syn-syn) | Beispiel 12b (anti-anti-anti) |
| 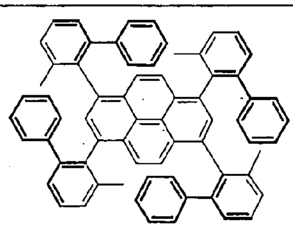 | 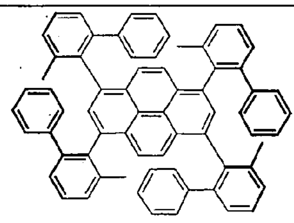 |
| Beispiel 13a (syn-syn-syn) | Beispiel 13b (anti-anti-anti) |
| 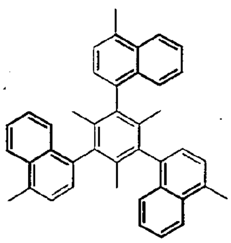 | 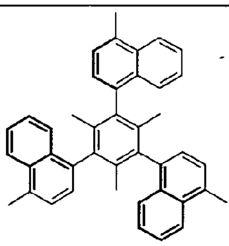 |
| Beispiel 14a (syn-syn) | Beispiel 14b (syn-anti) |

Atropisomerengemische der Formel (1), in denen A und gegebenenfalls auch D und G für kondensierte aromatische Ringsysteme stehen, die zur Bildung von Diastereomeren befähigt sind und in denen ein Überschuss eines Atropisomers (Diastereomers) gegenüber dem anderen Atropisomer (Diastereomer) vorliegt, sind neu und daher ebenfalls ein Gegenstand der vorliegenden Erfindung.

Gegenstand der Erfindung sind daher weiterhin Atropisomerengemische gemäß Formel (1),

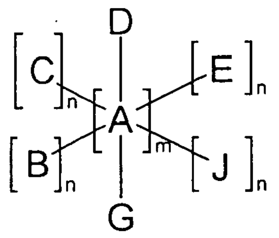

Formel (1)

wobei R, $R^1$, m und n dieselbe Bedeutung haben, wie oben beschrieben, und für die weiteren verwendeten Symbole gilt:

| | |
|---|---|
| A | ist bei jedem Auftreten gleich oder verschieden ein kondensiertes aromatisches Ringsystem mit 4 bis 40 C-Atomen, das durch R substituiert oder unsubstituiert sein kann, mit der Maßgabe, dass in allen ortho-Positionen zur Verknüpfung zu B, C, D, E, G bzw. J (bzw. auch zur Verknüpfung zu anderen A, falls m > 1) nicht direkt ein Wasserstoffatom gebunden ist, sondern eine Gruppe R oder eine Gruppe B, C, D, E, G bzw. J, bzw. dass diese Position durch einen Teil des kondensierten aromatischen Ringsystems blockiert ist; und weiterhin mit der Maßgabe, dass im aromatischen oder heteroaromatischen Ringsystem keine Einfachbindung vorhanden ist, um die freie Rotation möglich ist; |
| B, C, D, E, G, J | ist bei jedem Auftreten gleich oder verschieden ein aromatisches oder heteroaromatisches Ringsystem mit 2 bis 40 C-Atomen, das unsubstituiert oder durch R substituiert sein kann, mit der Maßgabe, dass in ortho-Position zur Verknüpfung zu A mindestens ein aromatischer Rest R vorhanden ist, der auch an die entsprechende Einheit B bis J ankondensiert sein kann; |

dadurch gekennzeichnet, dass ein Atropisomerenüberschuss eines Atropisomers von mindestens 10 % vorliegt.

Das Atropisomerengemisch der Formel (1) besteht bevorzugt nur aus den Atropisomeren einer Verbindung, d. h. es handelt sich bevorzugt um eine Mischung von Atropisomeren, ohne dass die Mischung weitere Komponenten enthält.

Bevorzugt ist ein Atropisomerenüberschuss von mindestens 20 %, besonders bevorzugt von mindestens 50 %, ganz besonders bevorzugt von mindestens 70 %, mindestens 90 %, mindestens 95 % bzw. mindestens 99 %. Größere Atropisomerenüberschüsse sind bevorzugt, da dadurch eine bessere Reproduzierbarkeit bei Herstellung und Betrieb der organischen elektronischen Vorrichtung gewährleistet ist.

Bevorzugte kondensierte aromatische Ringsysteme sind solche, wie sie bereits oben ausgeführt wurden.

Besonders bevorzugt ist A ausgewählt aus den Einheiten 9,10-Anthracen, Pyren, Perylen. Weiterhin besonders bevorzugt sind die entsprechenden Aza-Analoga. Ganz besonders bevorzugt ist A ausgewählt aus 9,10-Anthracen und Pyren.

Besonders bevorzugt sind B, C, D, E, G und J unabhängig voneinander ausgewählt aus 1-Naphthyl, ortho-Biphenyl, 1-Anthryl. Weiterhin besonders bevorzugt sind diese Gruppen ausgewählt aus den entsprechenden Aza-Analoga.

Die Synthese der Verbindungen gemäß Formel (1) erfolgt gewöhnlicherweise zunächst, indem gemäß der Literatur die Mischung der Atropisomeren synthetisiert wird, die statistisch in einem Verhältnis von ca. 1 : 1 vorliegen. Die Anreicherung und Isolierung eines der Atropisomeren kann in einem Folgeschritt beispielsweise durch Ausnutzung unterschiedlicher Löslichkeit erfolgen, beispielsweise durch Umkristallisation. Dabei kann es nötig oder nützlich sein, die Verbindung gemäß Formel (1) geeignet zu substituieren, wodurch sich die Löslichkeit der unterschiedlichen Atropisomere zu unterschiedlichem Anteil ändern kann. So kann es beispielsweise durch geeignete Substitution möglich sein, ein Atropisomer zu erhalten, welches gut in einer großen Bandbreite organischer Lösemittel löslich ist, während das andere Atropisomer, das zum ersten Atropisomer diastereomer ist, in diesen Lösemitteln nahezu unlöslich ist. Erst dadurch kann in manchen Fällen die Trennung der Isomere einfach möglich werden, die ansonsten nur mit hohem experimentellem Aufwand möglich wäre. Auch weitere gängige Trennmethoden der organischen Chemie können eingesetzt werden, so beispielsweise Säulenchromatographie, präparative HPLC, Destillation, Sublimation, fraktionierte Kristallisation oder Extraktion (z. B. Soxhlett-Extraktion). Sollen zusätzlich zu den Diastereomeren einzelne Enantiomere angereichert oder isoliert werden, bietet sich hierfür die Chromatographie an chiralen Festphasen an.
Auch die Ausnutzung des Templat-Effekts kann für die Synthese möglich sein: Dabei wird eines der möglichen Atropisomere bereits in Lösung bei der Synthese durch Zugabe eines Templats (beispielsweise ein geeignetes Metallion) selektiert und dadurch im deutlichen Überschuss gebildet.

Das Atropisomere, das nicht angereichert bzw. isoliert wird, kann durch Reisomerisierung, beispielsweise durch ausreichend langes Erhitzen in einem geeigneten Lösemittel, durch Behandlung mit Ultraschall und/oder mit Mikrowellen, wieder mit dem anderen Atropisomeren ins Gleichgewicht gebracht werden. Der Vorgang der Isomerentrennung kann also ohne Verlust durchgeführt werden.

Wie.oben ausgeführt, ist es durch geeignete Substitution möglich, gut lösliche bzw. unlösliche Atropisomere derselben Verbindung zu erhalten. Auf analoge Weise ist es möglich, beispielsweise durch Verwendung des löslicheren Atropisomeren als Monomer gut lösliche Polymere, Oligomere oder Dendrimere zu erhalten, ohne dass viele und/oder große organische Reste nötig sind, die nichts zur elektronischen Funktion des Polymers beitragen, die jedoch bislang zur Synthese löslicher konjugierter Polymere nach Stand der Technik nötig sind. Wird hingegen das weniger lösliche Atropisomer oder eine Mischung der beiden Atropisomere verwendet, die das unlöslichere Atropisomer zu gleichen Anteilen oder im Überschuss enthält, so sind im Allgemeinen auch die erhaltenen Polymere, Oligomere oder Dendrimere schlecht löslich.

Gegenstand der Erfindung sind daher weiterhin konjugierte, teilkonjugierte oder nicht-konjugierte Polymere, Oligomere oder Dendrimere, enthaltend Wiederholeinheiten, die Atropisomere bilden und dadurch zur Bildung von Diastereomeren befähigt sind, dadurch gekennzeichnet; dass ein Atropisomerenüberschuss von mindestens 10 % verwendet wird.

So können diese Wiederholeinheiten unter anderem in Polyfluorene (z. B. gemäß EP 842208 oder WO 00/22026), Poly-spirobifluorene (z. B. gemäß EP 707020 oder EP 894107), Poly-para-phenylene (z. B. gemäß WO 92/18552), Polydihydrophenanthrene (z. B. gemäß DE 10337346.2), Poly-phenanthrene (z. B. gemäß DE 102004020298.2), Poly-indenofluorene (z. B. gemäß WO 04/041901 oder EP 03014042.0), Poly-carbazole, Poly-anthracene, Poly-naphthaline oder auch Polythiophene (z. B. gemäß EP 1028136) einpolymerisiert werden. Auch Polymere mit mehreren dieser Einheiten oder Homopolymere der atropisomeren Wiederholeinheiten sind möglich.

Es ist bevorzugt, dass im Polymer, Oligomer oder Dendrimer das Atropisomer, das im Überschuss verwendet wird, besser löslich ist als das Atropisomer, das im Unterschuss verwendet wird.

In einer bevorzugten Ausführungsform der Erfindung ist der Atropisomerenüberschuss im Polymer, Oligomer oder Dendrimer mindestens 20 %, besonders bevorzugt mindestens 50 %, ganz besonders bevorzugt mindestens 70 %, mindestens 90 %, mindestens 95 % bzw. mindestens 99 %. Größere Atropisomerenüberschüsse sind bevorzugt, da dadurch eine bessere Löslichkeit der Polymere, Oligomere oder Dendrimere gewährleistet ist.

Weiterhin bevorzugt ist eine organische elektronische Vorrichtung, dadurch gekennzeichnet, dass eine oder mehrere Schichten mit einem Sublimationsverfahren beschichtet werden. Dabei werden die Materialien in Vakuum-Sublimationsanlagen bei einem Druck kleiner $10^{-5}$ mbar, bevorzugt kleiner $10^{-6}$ mbar, besonders bevorzugt kleiner $10^{-7}$ mbar aufgedampft.

Bevorzugt ist ebenfalls eine organische elektronische Vorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien in der Regel bei einem Druck zwischen $10^{-5}$ mbar und 1 bar aufgebracht.

Weiterhin bevorzugt ist eine organische elektronische Vorrichtung, dadurch gekennzeichnet, dass eine oder mehrere Schichten aus Lösung, wie z. B. durch Spincoating, oder mit einem beliebigen Druckverfahren, wie z. B. Siebdruck, Flexodruck oder Offsetdruck, besonders bevorzugt aber LITI (Light Induced Thermal Imaging, Thermotransferdruck) oder Ink-Jet Druck (Tintenstrahl-Druck), hergestellt werden.

Die oben beschriebenen emittierenden Vorrichtungen weisen folgende überraschende Vorteile gegenüber dem Stand der Technik, der Mischungen mit einem Atropisomerenverhältnis von ca. 1 : 1 verwendet, auf:

1. Die Stabilität entsprechender Vorrichtungen ist größer im Vergleich zu Systemen gemäß dem Stand der Technik, was sich vor allem in einer längeren Lebensdauer zeigt.
2. Die organischen elektronischen Vorrichtungen lassen sich mit besserer Reproduzierbarkeit herstellen, da statt Stoffmischungen, deren Einzelkomponenten unterschiedliche Sublimationstemperaturen und andere physikalische Eigenschaften aufweisen, Verbindungen mit starker Anreicherung eines Isomeren verwendet werden. Diese führen auch in der Vorrichtung zu einheitlicheren Schichten und zu besserer Reproduzierbarkeit im Betrieb der Vorrichtung.
3. Im Gegensatz zu bisher verwendeten Verbindungen, die teilweise durch schlechte Löslichkeit schwierig zu reinigen waren, können durch die Anreicherung löslichere Isomere isoliert werden, die in Folge einfacher zu reinigen sind bzw. auch leichter aus Lösung verarbeitet werden können.

4. Überraschend wurde gefunden, dass die Atropisomere trotz der verwendeten hohen Temperaturen bei der Sublimation im Hochvakuum stabil sind und nicht oder nur in ganz untergeordnetem Maße beim Aufdampfen isomerisieren. Dies ist eine wesentliche Eigenschaft, um zu gewährleisten, dass das eingesetzte Isomer auch in der organischen elektronischen Vorrichtung in derselben Form vorliegt.

5. Bei der Trennung der Isomere muss das nicht verwendete Isomer nicht verworfen werden, sondern dieses kann durch ausreichend langes Erhitzen in einem geeigneten Lösemittel oder andere Behandlung wieder mit dem anderen Atropisomeren ins Gleichgewicht gebracht werden. Der Vorgang der Isomerentrennung kann so ohne Verlust durchgeführt werden.

Die Erfindung wird durch die nachfolgenden Beispiele näher erläutert, ohne sie dadurch einschränken zu wollen.

**Beispiele:**

Die nachfolgenden Synthesen wurden, sofern nicht anders angegeben, unter einer Schutzgasatmosphäre durchgeführt. Die Edukte wurden von den Fa. ALDRICH bzw. ABCR (9,10-Dibromanthracen, 4-Methylnaphthalin-1-boronsäure, Palladium(II)acetat, Tri-o-tolylphosphin, Anorganika, Lösemittel) bezogen.

**Beispiel 1: 9,10-Bis(4-methylnaphth-1-yl)anthracen (Anthracen-Derivat A1)**

**a) Synthese des Atropisomerengemischs von Anthracen-Derivats A1**

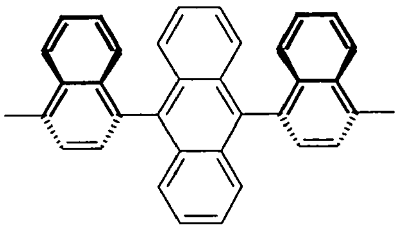

syn-Form

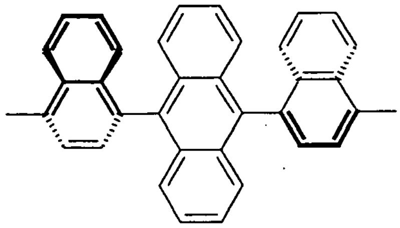

anti-Form

Eine entgaste, gut gerührte Suspension von 74.4 g (400 mmol) 4-Methylnaphthalin-1-boronsäure, 33.6 g (100 mmol) 9,10-Dibromanthracen und 104.3 g (420 mmol) Kaliumphosphat-monohydrat in einem Gemisch aus 300 ml Toluol, 150 ml Dioxan und 400 ml Wasser wurde mit 1.83 g (6 mmol) Tris-o-tolylphosphin und dann mit 225 mg (1 mmol) Palladium (II)acetat versetzt und anschließend 16 h unter Rückfluss erhitzt. Nach Erkalten der Reaktionsmischung auf Raumtemperatur wurde vom ausgefallenen Feststoff abgesaugt. Dieser wurde dreimal mit je 200 ml Wasser und dreimal mit je 100 ml Ethanol gewaschen. Nach Trocknen im Vakuum (1 mbar, 80 °C, 16 h) wurde das Produkt in einem Soxhlett-Extraktor mit Chloroform durch eine Glasfaserextraktionshülse (Porengröße 0.1 μm) extrahiert, um Palladiumspuren zu entfernen. Das Chloroform wurde auf ein Volumen von 100 ml eingeengt und mit 500 ml Ethanol versetzt. Der resultierende Niederschlag wurde abgesaugt und mit Ethanol gewaschen. Die Ausbeute an Rohprodukt A1 betrug 41.3 g (90 mmol), 90.0 % der Theorie.

**b) Bestimmung des Atropisomerenverhältnisses des Rohprodukts von A1 *Mittels HPLC:***

2 mg des oben beschriebenen Rohprodukts wurden in 10 ml THF gelöst. 5 μl dieser Lösung wurden unter Verwendung eines Agilent LC 1100 HPLC auf einer Zorbax SB-C18 (4.5 x 75 mm, 3.5 Mikron) bei 40 °C und einer Flussrate des Eluenten (72 % Methanol / 8 % THF / 20 % Wasser) von 1 ml/min getrennt.
Die Retentionszeiten [min] und Flächen-% der Atropisomeren betrugen:

| | | |
|---|---|---|
| Atropisomer **1**: | 32.45 min | ca. 47 Flächen-% |
| Atropisomer **2**: | 33.84 min | ca. 53 Flächen-% |

Dies entspricht einem Atropisomerenüberschuss von ca. 6 %. Die UV/Vis-Spektren beider Atropisomeren - entnommen

aus den HPLC-Peaks - sind nahezu identisch.

***Mittels ¹H-NMR-Spektroskopie:***

Die $^1$H-NMR-Spektren wurden auf einem DMX-500 MHz Spektrometer der Fa. Bruker aufgenommen.
Das $^1$H-NMR-Spektrum des oben beschriebenen Atropisomerengemischs ist, bedingt durch die weitgehende Überlappung der Signale der Atropisomere 1 und 2, komplex; jedoch kann das relative molare Verhältnis der Atropisomeren aus zwei überlagerten, aber ausreichend separierten Dubletts, die den 8-Naphthyl-Protonen zuzuordnen sind, bestimmt werden:
Atropisomer **1**: δ (8-Naphthyl-Proton): 8.21 ppm (d, $^3J_{HH}$ = 8.3 Hz); ca. 46 % Atropisomer **2**: δ (8-Naphthyl-Proton): 8.20 ppm (d, $^3J_{HH}$ = 8.3 Hz); ca. 54 %

**c) Präparative Trennung der Atropisomeren von A1**

***Anreicherung des Atropisomeren 2:***

40.0 g des oben als Rohprodukt beschriebenen Gemischs der Atropisomeren von **A1** mit einem Verhältnis von Atropisomer **1** zu Atropisomer **2** von ca. 47 % : 53 % wurden in 2000 ml N-Methylpyrrolidinon (NMP) suspendiert. Diese Suspension wurde in ein 250 °C warmes Ölbad gestellt. Nach ca. 10 min. betrug die Temperatur des N-Methylpyrrolidinon etwa 200 °C, und das Gemisch der Atropisomeren war in Lösung gegangen. Nach langsamen Erkalten der Lösung wurde der entstandene feinkristalline Niederschlag abgesaugt, dreimal mit je 100 ml mit NMP und dreimal mit 100 ml Ethanol gewaschen. Die Ausbeute betrug 18.3 g, wobei es sich um ein angereichertes Gemisch der Atropisomeren **1** und **2** im Verhältnis von ca. 10 % : 90 % handelt, entsprechend einem Atropisomerenüberschuss von **2** von 80 %.

***Anreicherung des Atropisomeren 1:***

Die N-Methylpyrrolidinon-Mutterlauge aus obiger Umkristallisation wurde mit 300 ml Ethanol versetzt. Der nach 16 h stehen bei Raumtemperatur entstandene feinkristalline Niederschlag wurde abgesaugt. Die so erhaltenen 5.4 g Produkt bestanden aus einem angereicherten Gemisch der Atropisomeren **1** und **2** im Verhältnis von ca. 84 % : 16 %, entsprechend einem Atropisomerenüberschuss von 68 %. Die Mutterlauge aus dem letztgenannten Schritt wurde erneut mit 500 ml Ethanol versetzt. Der nach 32 h stehen bei Raumtemperatur entstandene feinkristalline Niederschlag wurde abgesaugt. Die so erhaltenen 11.3 g Produkt bestanden aus einem angereicherten Gemisch der Atropisomeren **1** und **2** im Verhältnis von ca. 96 % : 4 %, entsprechend einem Atropisomerenüberschuss von **1** von 92 %.

***Reinisolierung des Atropisomeren 2:***

10.0 g des oben beschriebenen Gemischs, in dem das Atropisomer **2** auf einen Atropisomerenüberschuss von 80 % angereichert wurde, wurde erneut aus N-Methylpyrrolidinon umkristallisiert. Dazu wurden 800 ml N-Methylpyrrolidinon auf 190 °C erhitzt. Dann wurde das Gemisch mit einem Atropisomerenüberschuss des Atropisomeren **2** von 80 % unter gutem Rühren zugegeben. Nachdem eine klare Lösung entstanden war (ca. 5 min.), wurde die Heizquelle entfernt, und die Lösung kühlte unter Rühren auf Raumtemperatur ab (ca. 16 h). Der Feststoff wurde abgesaugt und mit etwas N-Methylpyrrolidinon gewaschen.
Nach zwei Umkristallisationen betrug die Ausbeute 7.9 g, wobei der Atropisomerenüberschuss an Atropisomer **2** auf mindestens 98 % abgeschätzt wird (Verhältnis 99 % : 1 %), da das Atropisomer **1** in dieser Fraktion weder mittels HPLC noch mittels $^1$H-NMR-Spektroskopie nachgewiesen werden konnte.

**d) Vergleich der Löslichkeit der Atropisomeren von A1**

Das Atropisomer 1 ist in allen gängigen, polaren organischen Lösungsmitteln, wie z. B. Dichlormethan, Chloroform, Aceton, THF, DMSO, DMF, NMP, etc., gut löslich. Im Gegensatz dazu ist das Atropisomer **2** in allen gängigen organischen Lösungsmitteln nur sehr schwer löslich. Die beste Löslichkeit zeigt es noch in dipolar aprotischen Lösungsmitteln wie DMF, NMP oder DMSO in der Siedehitze, aus welchen es auch umkristallisiert werden kann (s. o.).

**e) Thermische Isomerisierung der Atropisomeren von A1**

200 mg des Atropisomeren **2** mit einem Atropisomerenüberschuss von mindestens 98 % wurden in 10 ml N-Methylpyrrolidinon suspendiert. Diese Suspension wurde 6 h auf 200 °C erhitzt. Anschließend wurde der Atropisomerenüberschuss mittels HPLC (s. o.) bestimmt; er betrug 78 % bezüglich Atropisomer **2.** Durch längeres Erhitzen kann

auch eine Mischung mit einem Atropisomerenverhältnis von ca. 1 : 1 erzeugt werden. Dies zeigt, dass durch geeignete experimentelle Bedingungen aus dem angereicherten Isomer wieder eine Isomerenmischung erzeugt werden kann. Dadurch muss das nicht verwendete Isomer nicht verworfen werden, sondern kann, nach Isomerisierung, weiterhin verwendet werden.

**f) Sublimation der Atropisomeren von A1**

Die Sublimation der Atropisomeren von **A1** erfolgte im statischen Vakuum bei den unten angegebenen Bedingungen (Tabelle 2). Überraschend wurde gefunden, dass die Atropisomere unter den verwendeten Bedingungen der Sublimation nicht oder nur in ganz untergeordnetem Maße isomerisieren, wie der Vergleich des Atropisomerenüberschuss vor und nach der Sublimation zeigt. Weiterhin fällt auf, dass sich die beiden Atropisomeren stark in ihren Sublimationstemperaturen unterscheiden, was belegt, dass mit einer Mischung dieser Isomeren keine reproduzierbare Herstellung organischer elektronischer Vorrichtungen möglich ist.

Tabelle 2: Sublimation der Atropisomeren **1** und **2**

| Atropisomer | Druck [mbar] | Subl.-Temp. [°C] | Atropisomerenüberschuss vor Sublimation | Atropisomerenüberschuss nach Sublimation |
|---|---|---|---|---|
| **1** | 5 x $10^{-5}$ mbar | 320 | 92 % | 92 % |
| **2** | 5 x $10^{-5}$ mbar | 370 | 98 % | 97 % |

**g) Schmelz- und Glasübergangstemperaturen der Atropisomeren von A1**

Die Schmelzpunkte und die Glasübergangstemperaturen der beiden angereicherten Atropisomeren von **A1** wurde untersucht. Dabei wurde festgestellt, dass diese Temperaturen für die beiden Atropisomeren deutlich voneinander abweichen, was die unterschiedlichen morphologischen Eigenschaften der beiden Isomere belegt. Die Ergebnisse sind in Tabelle 3 zusammengefasst.

Tabelle 3: Schmelzpunkte und Glasübergangstemperaturen der Atropisomeren **1** und **2**

| Atropisomer | Atropisomerenüberschuss | Schmelzpunkt [°C] | Glasübergangs-temperatur [°C] |
|---|---|---|---|
| **1** | 92 % | 433 | 137 |
| **2** | 97 % | 449 | 151 |

**h) UV/Vis- und Photolumineszenzspektren der Atropisomeren von A1**

Von den Atropisomeren von **A1** (Atropisomer **1** mit 92 % Atropisomerenüberschuss und Atropisomer **2** mit 97 % Atropisomerenüberschuss) wurden die UVNis- und die Photolumineszenzspektren im Film bestimmt. Die Ergebnisse sind in Figur 1 gezeigt. Es fällt auf, dass, obwohl die UV/Vis-Spektren keine starken Unterschiede aufweisen, sich die Photolumineszenzspektren erheblich voneinander unterscheiden. So zeigt das Atropisomer **2** in der Photolumineszenz eine strukturierte Emissionsbande, während das Atropisomer **1** eine breite, kaum strukturierte Emissionsbande aufweist, die außerdem deutlich bathochrom verschoben ist.

**Patentansprüche**

1. Organische elektronische Vorrichtungen, enthaltend Kathode, Anode und mindestens eine Schicht, enthaltend mindestens eine organische Verbindung, die Atropisomerie aufweist und **dadurch** zur Bildung von Diastereomeren befähigt ist, **dadurch gekennzeichnet, dass** ein Atropisomerenüberschuss von mindestens 10% vorliegt.

2. Organische elektronische Vorrichtung gemäß Anspruch 1, **dadurch gekennzeichnet, dass** sie ausgewählt ist aus der Gruppe elektronischer Vorrichtungen, bestehend aus organischen und polymeren Leuchtdioden (OLEDs, PLEDs), organischen Feld-Effekt-Transistoren (O-FETs), organischen Dünnfilmtransistoren (O-TFTs), organischen integrierten Schaltungen (O-ICs), organischen Solarzellen (O-SCs), organischen Feld-Quench-Vorrichtungen und organischen Laserdioden (O-Laser).

**3.** Organische elektronische Vorrichtung gemäß Anspruch 1 und/oder 2, **dadurch gekennzeichnet, dass** die Verbindung, die Atropisomerie aufweist, als Host-Material für Dotanden, die aus dem Singutett- oder aus dem Triplett-Zustand Licht emittieren können, als Dotand, als Lochtransportmaterial, als Elektronentransportmaterial oder als Lochblockiermaterial eingesetzt wird.

**4.** Organische elektronische Vorrichtung gemäß einem oder mehreren der Ansprüche 1 bis 3, **dadurch gekennzeichnet, dass** sie außer der Schicht, die die Verbindung enthält, die Atropisomerie aufweist, noch weitere Schichten enthält.

**5.** Organische elektronische Vorrichtung gemäß einem oder mehreren der Ansprüche 1 bis 4, **dadurch gekennzeichnet, dass** als Atropisomerenüberschuss der entsprechende Diastereomerenüberschuss betrachtet wird.

**6.** Organische elektronische Vorrichtung gemäß einem oder mehreren der Ansprüche 1 bis 5, **dadurch gekennzeichnet, dass** die Aktivierungsenergie für die Rotation um die rotationsgehinderten Einfachbindungen mindestens 80 kJ/mol beträgt.

**7.** Organische elektronische Vorrichtung gemäß Anspruch 6, **dadurch gekennzeichnet, dass** die Aktivierungsenergie für die Rotation um die rotationsgehinderten Einfachbindungen mindestens 100 kJ/mol beträgt.

**8.** Organische elektronische Vorrichtung gemäß einem oder mehreren der Ansprüche 1 bis 7, **dadurch gekennzeichnet, dass** die Atropisomerie durch gehinderte Rotation um Einfachbindungen zwischen zwei $sp^2$-Zentren erzeugt wird.

**9.** Organische elektronische Vorrichtung gemäß einem oder mehreren der Ansprüche 1 bis 8, **dadurch gekennzeichnet, dass** die Atropisomerie durch gehinderte Rotation um C-C-Einfachbindungen erzeugt wird.

**10.** Organische elektronische Vorrichtung gemäß einem oder mehreren der Ansprüche 1 bis 9, **dadurch gekennzeichnet, dass** ein Atropisomerenüberschuss von mindestens 20 % verwendet wird.

**11.** Organische elektronische Vorrichtung gemäß einem oder mehreren der Ansprüche 1 bis 10, **dadurch gekennzeichnet, dass** die Verbindung, die Atropisomerie aufweist, zwei Einfachbindungen mit gehinderter Rotation enthält und das überwiegend vorliegende Atropisomer das syn-Isomer ist.

**12.** Organische elektronische Vorrichtung gemäß einem oder mehreren der Ansprüche 1 bis 10, **dadurch gekennzeichnet, dass** die Verbindung, die Atropisomerie aufweist, zwei Einfachbindungen mit gehinderter Rotation enthält und das überwiegend vorliegende Atropisomer das anti-Isomer ist.

**13.** Organische elektronische Vorrichtung gemäß einem oder mehreren der Ansprüche 1 bis 10, **dadurch gekennzeichnet, dass** die Verbindung, die Atropisomerie aufweist, drei Einfachbindungen mit gehinderter Rotation enthält, wobei die Einfachbindungen, um die Atropisomerie vorliegt, linear oder verzweigt angeordnet sind.

**14.** Organische elektronische Vorrichtung gemäß einem oder mehreren der Ansprüche 1 bis 10, **dadurch gekennzeichnet, dass** die Verbindung, die Atropisomerie aufweist, vier Einfachbindungen mit gehinderter Rotation enthält, wobei die Einfachbindungen, um die Atropisomerie vorliegt, linear oder verzweigt angeordnet sind.

**15.** Organische elektronische Vorrichtung gemäß einem oder mehreren der Ansprüche 1 bis 14, **dadurch gekennzeichnet, dass** die Verbindung, die Atropisomerie aufweist, eine Verbindung gemäß Formel (1) ist,

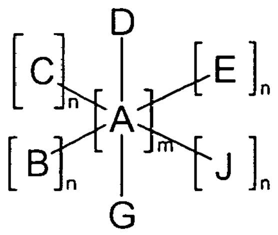

Formel (1)

wobei für die Symbole gilt:

A ist bei jedem Auftreten gleich oder verschieden ein aromatisches oder heteroaromatisches Ringsystem mit 2 bis 40 C-Atomen, das durch R substituiert oder unsubstituiert sein kann, mit der Maßgabe, dass in allen ortho-Positionen zur Verknüpfung zu B, C, D, E, G bzw. J (bzw. auch zur Verknüpfung zu anderen A, falls m >1) nicht direkt ein Wasserstoffatom gebunden ist, sondern eine Gruppe R oder eine Gruppe B, C, D, E, G bzw. J, bzw. dass diese Position blockiert ist, wenn A ein kondensiertes aromatisches Ringsystem darstellt; und weiterhin mit der Maßgabe, dass im aromatischen oder heteroaromatischen Ringsystem keine Einfachbindung vorhanden ist, um die freie Rotation möglich ist;

B, C, D, E, G, J ist bei jedem Auftreten gleich oder verschieden ein aromatisches oder heteroaromatisches Ringsystem mit 2 bis 40 C-Atomen, das unsubstituiert oder durch R substituiert sein kann, mit der Maßgabe, dass in mindestens einer ortho-Position zur Verknüpfung zu A nicht direkt ein Wasserstoffatom gebunden ist, sondern eine Gruppe R, bzw. dass diese Position blockiert ist, wenn B, C, D, E, G bzw. J ein kondensiertes aromatisches Ringsystem darstellen;

R ist bei jedem Auftreten gleich oder verschieden F, Cl, Br, I, eine geradkettige, verzweigte oder cyclische Alkyl- oder Alkoxykette mit 1 bis 40 C-Atomen, die durch $R^1$ substituiert sein kann, in der auch ein oder mehrere nicht benachbarte C-Atome durch N-$R^1$, O, S, O-CO-O, CO-O, -$CR^1$=$CR^1$- oder -C=C- ersetzt sein können und in der auch ein oder mehrere H-Atome durch F, Cl, Br, I oder CN ersetzt sein können, oder ein aromatisches oder heteroaromatisches Ringsystem mit 2 bis 40 C-Atomen, welches auch durch einen oder mehrere Reste $R^1$ substituiert sein kann, oder eine Kombination aus zwei bis fünf dieser Systeme; dabei können zwei oder mehrere Reste R miteinander auch ein weiteres mono- oder polycyclisches, aliphatisches oder aromatisches Ringsystem bilden;

$R^1$ ist bei jedem Auftreten gleich oder verschieden H oder ein aliphatischer oder aromatischer Kohlenwasserstoffrest mit 1 bis 20 C-Atomen;

n ist bei jedem Auftreten gleich oder verschieden 0 oder 1;

m ist bei jedem Auftreten gleich oder verschieden 1, 2, 3, 4 oder 5.

**16.** Organische elektronische Vorrichtung gemäß Anspruch 15, **dadurch gekennzeichnet, dass** an A in allen ortho-Positionen zur Verknüpfung zu B, C, D, E, G und J mindestens ein Kohlenstoffatom gebunden ist, welches in einem kondensierten Ringsystem direkt an der aromatischen bzw. heteroaromatischen Einheit A vorhanden ist oder als Substituent R an A gebunden ist.

**17.** Organische elektronische Vorrichtung gemäß Anspruch 15 und/oder 16, **dadurch gekennzeichnet, dass** an B, C, D, E, G und J jeweils in mindestens einer ortho-Position zur Verknüpfung zu A mindestens ein Kohlenstoffatom gebunden ist, welches in einem kondensierten Ringsystem direkt an der aromatischen bzw. heteroaromatischen Einheit B, C, D, E, G bzw. J vorhanden ist oder als Substituent R an B, C, D, E, G bzw. J gebunden ist.

**18.** Organische elektronische Vorrichtung gemäß einem oder mehreren der Ansprüche 15 bis 17, **dadurch gekennzeichnet, dass** mindestens eine der Gruppen A, D und/oder G (und/oder gegebenenfalls B, C, E und J) ein kondensiertes aromatisches bzw. kondensiertes heteroaromatisches Ringsystem darstellen.

**19.** Organische elektronische Vorrichtung gemäß Anspruch 18, **dadurch gekennzeichnet, dass** das kondensierte aromatische Ringsystem zwischen zwei und acht aromatische, heteroaromatische oder andere cyclische Einheiten enthält, die jeweils über eine oder mehrere gemeinsame Kanten einander ankondensiert sind und **dadurch** gegebenenfalls ein gemeinsames aromatisches System ausbilden und die durch R substituiert oder unsubstituiert sein

können:

**20.** Organische elektronische Vorrichtung gemäß Anspruch 18 und/oder 19, **dadurch gekennzeichnet, dass** die einander ankondensierten Einheiten ausgewählt sind aus der Gruppe bestehend aus Benzol, Pyridin, Pyrimidin, Pyrazin, Pyridazin, Pyrrol und Thiophen, die durch R substituiert oder unsubstituiert sein können.

**21.** Organische elektronische Vorrichtung gemäß Anspruch 20, **dadurch gekennzeichnet, dass** die kondensierten aromatischen Ringsysteme ausgewählt sind aus der Gruppe bestehend aus Naphthalin, Anthracen, Phenanthren, Pyren, Naphthacen, Chrysen, Pentacen, Chinolin, Isochinolin, Chinoxalin, Phenanthrolin, Perylen, Triphenylen, Carbazol, Benzothiophen oder Dibenzothiophen, die gegebenenfalls durch R substituiert sein können.

**22.** Organische elektronische Vorrichtung gemäß einem oder mehreren der Ansprüche 18 bis 21, **dadurch gekennzeichnet, dass** das Symbol A für eine 9,10-verknüpfte Anthracen-Einheit steht.

**23.** Organische elektronische Vorrichtung gemäß einem oder mehreren der Ansprüche 1 bis 22, **dadurch gekennzeichnet, dass** eine oder mehrere Schichten mit einem Sublimationsverfahren beschichtet werden.

**24.** Organische elektronische Vorrichtung gemäß einem oder mehreren der Ansprüche 1 bis 22, **dadurch gekennzeichnet, dass** eine oder mehrere Schichten mit dem OVPD (Organic Vapour Phase Deposition) Verfahren oder mit Hilfe einer Trägergassublimation beschichtet werden.

**25.** Organische elektronische Vorrichtung gemäß einem oder mehreren der Ansprüche 1 bis 23, **dadurch gekennzeichnet, dass** eine oder mehrere Schichten aus Lösung oder mit einem Druckverfahren, insbesondere durch LITI (Light Induced Thermal Imaging) oder Ink-Jet Druck (Tintenstrahl-Druck), hergestellt werden.

**26.** Atropisomerengemisch, das zur Bildung von Diastereomeren befähigt ist, gemäß Formel (1),

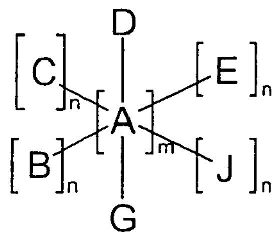

Formel (1)

wobei R, $R^1$, m und n dieselbe Bedeutung haben, wie oben beschrieben, und für die weiteren verwendeten Symbole gilt:

A ist bei jedem Auftreten gleich oder verschieden ein kondensiertes aromatisches Ringsystem mit 4 bis 40 C-Atomen, das durch R substituiert oder unsubstituiert sein kann, mit der Maßgabe, dass in allen ortho-Positionen zur Verknüpfung zu B, C, D, E, G bzw. J (bzw. auch zur Verknüpfung zu anderen A, falls m > 1) nicht direkt ein Wasserstoffatom gebunden ist, sondern eine Gruppe R oder eine Gruppe B, C, D, E, G bzw. J, bzw. dass diese Position durch einen Teil des kondensierten aromatischen Ringsystems blockiert ist; und weiterhin mit der Maßgabe, dass im aromatischen oder heteroaromatischen Ringsystem keine Einfachbindung vorhanden ist, um die freie Rotation möglich ist;
B, C, D, E, G, J ist bei jedem Auftreten gleich oder verschieden ein aromatisches oder heteroaromatisches Ringsystem mit 2 bis 40 C-Atomen, das unsubstituiert oder durch R substituiert sein kann, mit der Maßgabe, dass in ortho-Position zur Verknüpfung zu A mindestens ein aromatischer Rest R vorhanden ist, der auch an die entsprechende Einheit B bis J ankondensiert sein kann;

**dadurch gekennzeichnet, dass** ein Atropisomerenüberschuss von mindestens 10 % vorliegt.

**27.** Verbindungen gemäß Anspruch 26, **dadurch gekennzeichnet, dass** ein Atropisomerenüberschuss von mindestens 20 % vorliegt.

**28.** Verbindungen gemäß Anspruch 26 und/oder 27, **dadurch gekennzeichnet, dass** A ausgewählt ist aus der Gruppe bestehend aus substituiertem oder unsubstituiertem 9,10-Anthracen, Pyren oder Perylen.

**29.** Verbindungen gemäß einem oder mehreren der Ansprüche 27 bis 29, **dadurch gekennzeichnet, dass** B, C, D, E, G und J unabhängig voneinander ausgewählt sind aus der Gruppe bestehend aus substituiertem oder unsubstituiertem 1-Naphthyl, ortho-Biphenyl oder 1-Anthryl.

**30.** Konjugierte, teilkonjugierte oder nicht-konjugierte Polymere, Oligomere oder Dendrimere enthaltend Wiederholeinheiten, die Atropisomere bilden und **dadurch** zur Bildung von Diastereomeren befähigt sind, **dadurch gekennzeichnet, dass** ein Atropisomerenüberschuss von mindestens 10 % verwendet wird.

**31.** Polymere gemäß Anspruch 30, **dadurch gekennzeichnet, dass** es sich um Polyfluorene, Poly-spirobifluorene, Poly-para-phenylene, Polydihydrophenanthrene, Poly-phenanthrene, Poly-indenofluorene, Poly-carbazole, Poly-anthracene, Polynaphthaline oder Polythiophene handelt, aber auch Polymere mit mehreren dieser Einheiten oder Homopolymere der Verbindungen, die Atropisomerie aufweisen.

**32.** Polymere, Oligomere oder Dendrimere gemäß Anspruch 30 und/oder 31, **dadurch gekennzeichnet, dass** das im Polymer im Überschuss vorliegende Atropisomer dasjenige ist, welches besser löslich ist.

**33.** Polymere gemäß einem oder mehreren der Ansprüche 30 bis 32, **dadurch gekennzeichnet, dass** der Atropisomerenüberschuss mindestens 20 % beträgt.

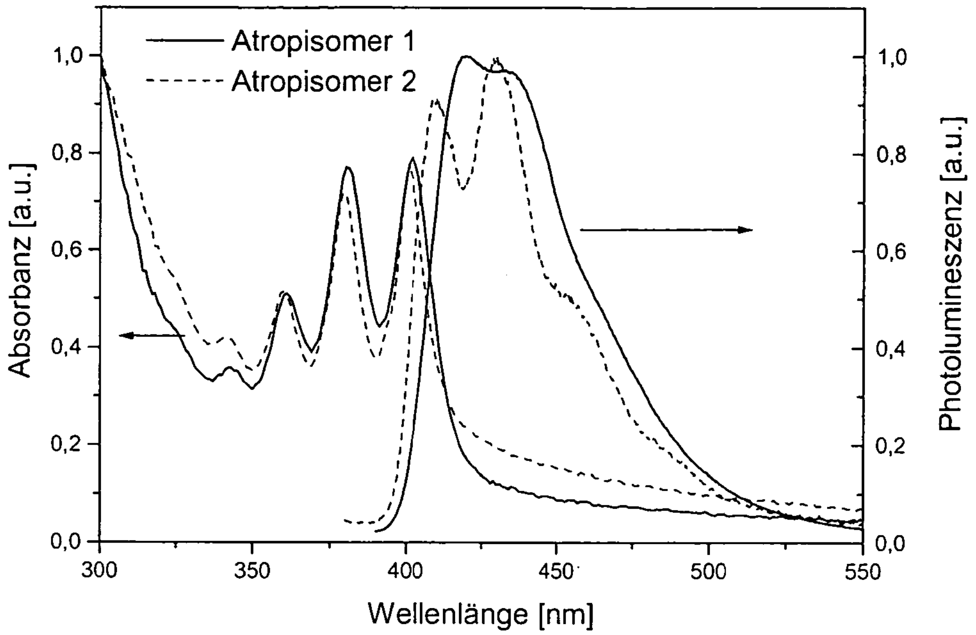


**Figur 1:** UV/vis- und Photolumineszenzspektren der Atropisomeren von **A1**

Europäisches Patentamt

## EUROPÄISCHER RECHERCHENBERICHT

Nummer der Anmeldung
EP 04 02 6402

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| X | US 5 929 239 A (LANGHALS ET AL) 27. Juli 1999 (1999-07-27) * Spalte 10, Zeile 19 - Zeile 23 * * Spalte 11, Zeile 3 - Zeile 13 * * Spalte 11, Zeile 42 - Zeile 44 * * Spalte 11, Zeile 59 - Spalte 12, Zeile 19 * ----- | 1-33 | C09K11/06 H01L51/30 |
| X | EP 0 952 200 A (EASTMAN KODAK COMPANY) 27. Oktober 1999 (1999-10-27) * Absatz [0006]; Ansprüche 1-10 * ----- | 1-33 | |
| X | US 5 886 183 A (LANGHALS ET AL) 23. März 1999 (1999-03-23) * Spalte 6, Zeile 6 - Zeile 7; Beispiel 11 * ----- | 1-33 | |
| X | EP 1 013 740 A (KONICA CORPORATION) 28. Juni 2000 (2000-06-28) * Absätze [0030], [0031] * ----- | 1-33 | RECHERCHIERTE SACHGEBIETE (Int.Cl.7) |
| D,X | HU N-X; XIE S; POPOVIC Z; ONG B; HOR A-M: "5,11-Dihydro-5,11-di-1-naphthylindolo[3,2-b]carbazole: Atropisomerism in a Novel Hole-Transport Molecule for Organic Light-Emitting Diodes" JOURNAL OF THE AMERICAN CHEMICAL SOCIETY, Bd. 121, 1999, Seiten 5097-5098, XP002331514 * das ganze Dokument * ----- | 1-33 | C09K H01L |

Der vorliegende Recherchenbericht wurde für alle Patentansprüche erstellt

| Recherchenort | Abschlußdatum der Recherche | Prüfer |
|---|---|---|
| Den Haag | 13. Juni 2005 | Lehnert, A |

3

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
& : Mitglied der gleichen Patentfamilie, übereinstimmendes Dokument

EPO FORM 1503 03.82 (P04C03)

## ANHANG ZUM EUROPÄISCHEN RECHERCHENBERICHT ÜBER DIE EUROPÄISCHE PATENTANMELDUNG NR.

EP 04 02 6402

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

13-06-2005

| Im Recherchenbericht angeführtes Patentdokument | Datum der Veröffentlichung | Mitglied(er) der Patentfamilie | Datum der Veröffentlichung |
|---|---|---|---|
| US 5929239 A | 27-07-1999 | DE 19702826 A1 | 20-08-1998 |
| | | AT 222277 T | 15-08-2002 |
| | | AU 730392 B2 | 08-03-2001 |
| | | AU 6094898 A | 18-08-1998 |
| | | CN 1104469 C | 02-04-2003 |
| | | CZ 9902639 A3 | 17-11-1999 |
| | | DE 69807189 D1 | 19-09-2002 |
| | | DE 69807189 T2 | 05-12-2002 |
| | | WO 9832799 A1 | 30-07-1998 |
| | | EP 0960167 A1 | 01-12-1999 |
| | | JP 2001511196 T | 07-08-2001 |
| EP 0952200 A | 27-10-1999 | US 5972247 A | 26-10-1999 |
| | | DE 69904528 D1 | 30-01-2003 |
| | | DE 69904528 T2 | 06-11-2003 |
| | | EP 0952200 A2 | 27-10-1999 |
| | | JP 11312588 A | 09-11-1999 |
| US 5886183 A | 23-03-1999 | CA 2187593 A1 | 13-04-1997 |
| | | DE 59608872 D1 | 18-04-2002 |
| | | EP 0769532 A1 | 23-04-1997 |
| | | JP 9124960 A | 13-05-1997 |
| EP 1013740 A | 28-06-2000 | EP 1013740 A2 | 28-06-2000 |
| | | JP 2001143869 A | 25-05-2001 |
| | | KR 2000052560 A | 25-08-2000 |
| | | US 6656608 B1 | 02-12-2003 |
| | | US 2004096696 A1 | 20-05-2004 |
| | | US 2004072019 A1 | 15-04-2004 |
| | | US 2004058195 A1 | 25-03-2004 |
| | | US 2004062951 A1 | 01-04-2004 |

EPO FORM P0461

Für nähere Einzelheiten zu diesem Anhang : siehe Amtsblatt des Europäischen Patentamts, Nr.12/82